# FASCICULE DE BREVET EUROPEEN

(11) **EP 1 107 292 B1**
(45) Date de publication et mention de la délivrance du brevet: **30.01.2008**
(21) Numéro de dépôt: 00420248.7
(22) Date de dépôt: 06.12.2000
(51) Int. Cl.: H01L 21/00, F04B 19/00

(54) **Système et procédé de contrôle de minienvironnement.**
Vorrichtung und Verfahren zur Steuerung einer Miniumgebung
Apparatus and process for controlling a mini-environment

(30) Priorité: 09.12.1999 FR 9915528
(43) Date de publication de la demande: 13.06.2001
(73) Titulaire: Alcatel Lucent, 75008 Paris (FR)
(72) Inventeur: Chevalier, Eric, 74940 Annecy le Vieux (FR); Bernard, Roland, 74540 Viuz-La-Chiesaz (FR)
(74) Mandataire: Korakis-Ménager, Sophie

(56) Documents cités:
- EP-A- 0 582 018
- EP-A- 0 854 498
- FR-A- 2 747 112
- US-A- 4 938 742
- US-A- 4 969 556
- US-A- 5 255 783
- US-A- 5 375 979
- US-A- 5 871 336
- US-A- 5 975 856
- US-A- 5 988 233

## Description

La présente invention concerne les dispositifs et procédés pour contrôler l'atmosphère qui entoure un échantillon tel que par exemple une tranche de substrat pour fabrication de semi-conducteurs, ou tout autre élément en cours de test ou de fabrication.

Dans l'industrie du semi-conducteur, par exemple, des systèmes de manutention de substrat sont actuellement utilisés pour isoler ces derniers des agents contaminants des salles blanches. Le principe réside dans l'introduction de plusieurs substrats dans un même boîtier collectif contenant de l'azote ou un autre gaz neutre sous pression, comme enseigné dans les documents EP 0 582 018 A ou US 5 988 233 A. Il n'y a pas de contrôle de l'atmosphère embarquée dans le boîtier. Un inconvénient est dû à la présence de l'azote ou autre gaz neutre, qui nécessite une étape transitoire de dégazage avant le traitement sous vide du substrat, dans une interface telle que décrite dans le même document EP 0 582 018 A. Un autre inconvénient est la contamination résultant des flux gazeux lors de la remise à pression de traitement, de sorte qu'on peut prévoir un dispositif de purge tel que décrit dans le document US 5 988 233 A.

Dans les documents US 5,255,783 A et EP 0 854 498 A, plusieurs substrats peuvent être transportés dans un même boîtier collectif dont l'atmosphère est en pression réduite établie par une source extérieure et pouvant contenir un gaz neutre de substitution. Il n'y a pas de contrôle de l'atmosphère du boîtier. Tout au plus le document EP 0 854 498 A enseigne un brassage et un filtrage continus de l'atmosphère intérieure, et la génération d'une surpression intérieure lors de l'ouverture de la porte d'accès. Tous les documents ci-dessus incitent à transporter collectivement les échantillons, en les groupant à plusieurs dans un même boîtier collectif.

On connaît par ailleurs diverses structures de micropompes telles que : des micropompes à transpiration thermiques, décrites dans le document US 5 871 336 A appliquées à la génération du vide dans un analyseur miniature de gaz à spectrographe de masse ou autre capteur miniature ; des micropompes à pompage par dilatation thermique des gaz, décrites dans le document US 5 375 979 A ; des micropompes à membranes actionnées par effet piézo-électrique, décrites dans le document US 4 938 742 A, pour le pompage de liquides ou de gaz dans les domaines des médicaments, de la biologie, des refroidissements et de l'alimentation en carburant ; des micropompes à pompage par variation volumique des gaz obtenue par jonctions à effet Peltier, décrites dans le document US 5 975 856 A, appliquées dans les capteurs d'accélération, de pression ou de composition chimique, ou dans la commande de fluides pour l'industrie pharmaceutique ou spatiale. Aucun de ces documents ne décrit ni ne suggère l'application au contrôle de l'atmosphère dans le traitement d'échantillons tels que des tranches de semi-conducteurs.

Un but de l'invention est de concevoir un dispositif qui permette de mettre et de conserver l'échantillon dans une atmosphère contrôlée qui soit la plus proche possible des conditions de traitement ou d'utilisation de l'échantillon, en évitant ou en réduisant sensiblement les étapes transitoires de modification et d'adaptation d'atmosphère qui étaient nécessaires entre plusieurs opérations successives de traitement ou de contrôle de l'échantillon.

Selon l'invention, on cherche à mettre et conserver l'échantillon au plus près des conditions d'usage ou de traitement.

Pour cela, l'invention prévoit un procédé de manipulation et de conservation d'un élément en cours de traitement ou de contrôle, comprenant une étape de transport sous vide contrôlé. Le transport s'effectue de manière individuelle dans un ensemble formé d'un réseau de micropompes solidaires d'une enceinte individuelle étanche conformée pour contenir un élément et dont les dimensions sont seulement légèrement supérieures à celles de l'élément, pour laisser autour de l'élément une atmosphère intérieure de volume réduit. On a pu constater que cela permet d'abaisser sensiblement le risque de contamination des échantillons.

L'enceinte individuelle est de taille peu supérieure à celle de l'échantillon à transporter, de sorte que l'échantillon placé dans l'enceinte est entouré d'une atmosphère à volume réduit, constituant un minienvironnement.

L'invention prévoit d'autre part un dispositif detransport et de stockage sous vide contrôlé d'un élément en cours de test ou de fabrication, comprenant une enceinte étanche pour isoler l'élément de l'atmosphère extérieure, des pompes solidaires de l'enceinte et adaptées pour générer et maintenir un vide contrôlé dans l'enceinte, les pompes étant connectables à une source d'énergie électrique, des moyens de transfert pour introduire ou extraire l'élément dans l'enceinte, dans lequel l'enceinte est une enceinte individuelle conformée pour contenir un élément qui a des dimensions légèrement supérieures à celles de l'élément de manière à laisser autour de l'élément une atmosphère intérieure de volume réduit, et les pompes sont constituées d'un réseau de micropompes solidaire de l'enceinte.

Le dispositif ainsi défini réalise un minienvironnement autour de l'échantillon, abaissant sensiblement le risque de contamination de l'échantillon.

Selon un premier mode de réalisation, l'ensemble formé par l'enceinte individuelle et le réseau de micropompes est un ensemble autonome portable incluant une source interne d'énergie électrique pour alimenter au moins temporairement le réseau de micropompes. Il est ainsi possible de déplacer l'échantillon entre deux postes de travail successifs, sans nécessiter d'opération transitoire de dégazage telle que celle qui était nécessaire avec les conteneurs à azote sous pression.

Selon une autre application, l'ensemble formé par l'enceinte individuelle et le réseau de micropompes peut être fixe et constitue alors une chambre de transfert dans une installation de fabrication de semi-conducteurs.

Selon une possibilité avantageuse, notamment pour constituer un ensemble autonome portable, le réseau de micropompes comprend des micropompes fonctionnant par effet de transpiration thermique. Les sources thermiques pour obtenir l'effet de transpiration thermique peuvent être des résistances électriques, ou des jonctions à effet Peltier. Un avantage de telles micropompes est de ne comporter aucune pièce en mouvement, et donc aucune pièce susceptible de s'user à cause des frottements. On peut ainsi obtenir une excellente fiabilité, et une absence de pertes dues au frottement.

Egalement, de telles micropompes évitent de libérer dans l'atmosphère des particules indésirables.

En alternative, on peut toutefois utiliser des micropompes à micromembranes, ou des micropompes à effet piézo-électrique, ou des micropompes à effet de dilatation thermique des gaz dans lesquelles l'échauffement des gaz peut être réalisé par des résistances électriques ou par des jonctions à effet Peltier.

L'atmosphère intérieure peut être contrôlée par des microcapteurs de température et de pression et un analyseur de gaz, commandant les micropompes par l'intermédiaire d'un microcalculateur embarqué.

D'autres objets, caractéristiques et avantages de la présente invention ressortiront de la description suivante de modes de réalisation particuliers, faite en relation avec les figures jointes, parmi lesquelles:
- la figure 1 illustre schématiquement en coupe une structure de réseau de micropompes à transpiration thermique, utilisable selon l'invention ;
- la figure 2 est une vue schématique en coupe d'un dispositif de contrôle d'atmosphère selon un mode de réalisation de la présente invention ; et
- la figure 3 illustre l'utilisation d'un dispositif de contrôle d'atmosphère selon l'invention, dans un mode de réalisation portable pour fabrication de semi-conducteurs.

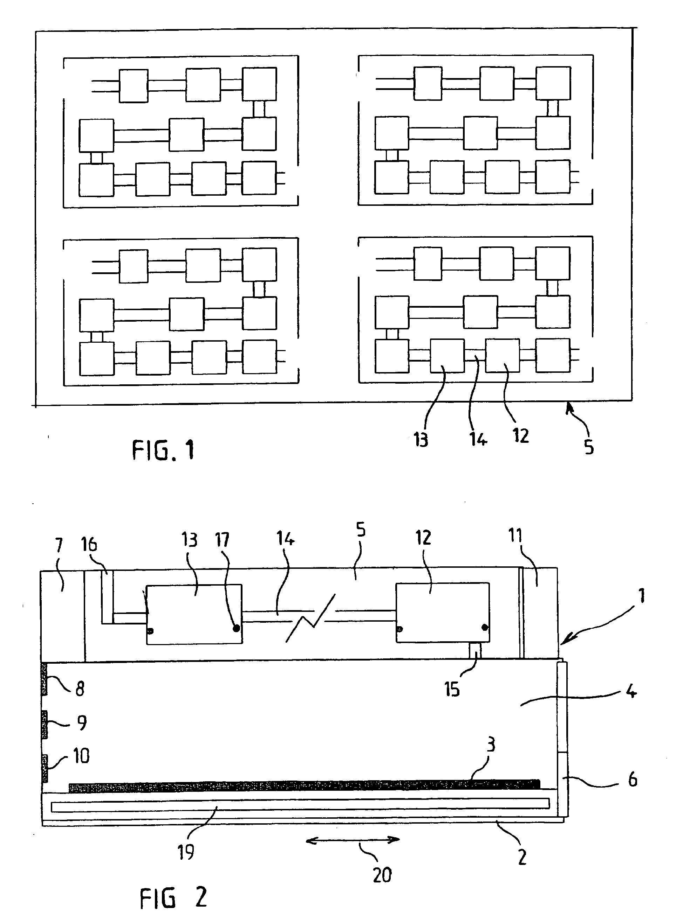

En se référant plus particulièrement à la figure 2, un dispositif de contrôle de l'atmosphère en minienvironnement selon l'invention comprend une enceinte individuelle 1 à paroi périphérique 2 étanche, conformée pour contenir un échantillon 3 et pour l'isoler de l'atmosphère extérieure en laissant à l'intérieur de l'enceinte individuelle 1 un volume réduit 4 autour de l'échantillon 3. Par exemple, pour une tranche de substrat semi-conducteur, la paroi périphérique 2 peut définir une chambre intérieure parallélépipédique plate dont les dimensions sont seulement légèrement supérieures à celles de la tranche de substrat.

Un réseau de micropompes 5, solidaire de l'enceinte individuelle 1, est adapté pour générer et maintenir un vide contrôlé dans l'enceinte individuelle 1. Le réseau de micropompes 5 est connectable à une source d'énergie électrique.

Des moyens de transfert, schématiquement illustrés par une porte 6 et un plateau de transfert 19 éventuellement motorisé et coulissant longitudinalement comme illustré par la double flèche 20, permettent d'introduire ou d'extraire l'échantillon 3 dans l'enceinte individuelle 1.

Dans le mode de réalisation de la figure 2, l'ensemble formé par l'enceinte individuelle 1 et le réseau de micropompes 5 est un ensemble autonome portable, incluant une source interne d'énergie électrique 7 pour alimenter au moins temporairement le réseau de micropompes 5 et ses organes de commande. Dans sa configuration portable, l'ensemble du dispositif peut avoir un diamètre de 200 à 500 mm environ, et une épaisseur de 30 à 50 mm environ.

Egalement, dans ce mode de réalisation de la figure 2, le dispositif comprend en outre des microcapteurs, tels que par exemple un microcapteur de température 8, un microcapteur de pression 9, et un analyseur de gaz 10, pour contrôler l'atmosphère dans l'enceinte individuelle 1 et pour commander le réseau de micropompes 5 par l'intermédiaire d'un microcalculateur embarqué 11. Le microcalculateur 11 est programmé pour commander le fonctionnement des micropompes 5 de façon à stabiliser l'atmosphère dans l'enceinte individuelle 1 autour de l'échantillon 3.

Dans le mode de réalisation illustré sur la figure 1, le réseau de micropompes 5 comprend des micropompes fonctionnant par effet de transpiration thermique. Selon l'effet de transpiration thermique, mis en évidence par Knudsen, lorsque deux grands volumes sont reliés par un canal de dimensions transversales très faibles, dont le rayon est inférieur au libre parcours moyen des molécules, et que les volumes sont à des températures différentes, une différence de pression s'établit entre les volumes. Avec une succession de canaux et de volumes, on peut donc générer une différence de pression depuis la pression atmosphérique jusqu'à un vide poussé.

Par exemple, sur la figure 1, en considérant deux chambres successives 12 et 13 reliées par un canal 14 de petite section, si la seconde chambre 13 est à température supérieure à la première chambre 12, avec par exemple une première chambre 12 à 300°K et une seconde chambre 13 à 600°K, la pression dans la seconde chambre 13 peut être 1,4 fois plus grande que la pression dans la première chambre 12. Le rapport des pressions est sensiblement proportionnel à la racine carrée du rapport des températures absolues des deux chambres 12 et 13.

Cet effet se produit même lorsque le canal 14 a une faible longueur, sa longueur étant toutefois suffisante pour permettre de conserver la différence de températures entre les deux chambres 12 et 13.

On comprend que l'on peut prévoir une pluralité de chambres reliées par une pluralité de canaux.

Ainsi, le réseau de micropompes 5 peut avantageusement comprendre une succession de chambres 12, 13 reliées par des canaux 14 dont au moins une dimension transversale est approximativement égale ou inférieure au libre parcours moyen des molécules de gaz présentes dans les micropompes 5, et avec des moyens pour créer et maintenir une différence de température entre les chambres successives 12, 13 afin de générer un effet de pompage.

Cette pluralité de chambres et de canaux peut être réalisée sur des substrats par les procédés de micro-usinage couramment utilisés en microtechnologie. Plusieurs séquences (des milliers) peuvent alors être réalisées sur une plaquette entière, de manière à augmenter significativement la capacité de pompage du réseau, pouvant atteindre plusieurs centaines de mbar.L/sec., et de manière à avoir des séquences nominales et redondantes. Il est important de noter qu'il n'y a aucune pièce en mouvement.

Dans un tel réseau de micropompes 5 à effet de transpiration thermique, il est nécessaire de créer et de maintenir une différence de température entre les chambres successives telles que les chambres 12 et 13 afin de générer un effet de pompage.

Comme on l'a représenté à plus grande échelle sur la figure 2, un réseau de micropompes 5 à transpiration thermique selon l'invention peut comprendre une entrée de pompe 15 connectée au volume intérieur 4 de l'enceinte individuelle 1 et une sortie de pompe 16 connectée à la pression atmosphérique. Le réseau de micropompes 5 reçoit un gaz à faible pression par son entrée 15 et rejette le gaz à pression atmosphérique par sa sortie 16.

Chacun des canaux de liaison tels que le canal 14 peut avoir une section transversale rectangulaire, plus facile à réaliser par micro-usinage, et au moins une dimension qui est approximativement égale ou inférieure au libre parcours moyen des molécules de gaz dans les conditions dans lesquelles elles se présentent dans le canal 14.

Pour générer l'effet de pompage, les moyens pour créer et maintenir une différence de température entre les chambres successives peuvent comprendre une résistance électrique 17 disposée de façon à chauffer les gaz dans la seconde chambre 13. La résistance électrique 17 peut avantageusement être disposée au voisinage de l'entrée de la seconde chambre 13 et alimentée par des moyens de commande et de régulation.

En alternative, les moyens pour créer et maintenir une différence de température comprennent des jonctions à effet Peltier, logées par exemple au voisinage des entrées des chambres 12 et 13 successives.

Le substrat dans lequel sont réalisées les chambres 12 et 13 et les canaux 14 peut être de préférence un matériau semi-conducteur tel que le silicium, la silice, l'arséniate de gallium, le carbure de silicium.

Pour des raisons de facilité de fabrication, on peut préférer des canaux à sections transversales rectangulaires, dans lesquels l'une des dimensions, telle que la largeur, est approximativement égale ou inférieure au libre parcours moyen des molécules.

Les gaz pompés hors de l'enceinte individuelle 1 traversent une pluralité d'étages à l'intérieur du réseau de micropompes 5. Les chambres et les canaux peuvent avoir une taille plus réduite au fur et à mesure que la pression de gaz augmente, car le libre parcours moyen des molécules décroît lorsque la pression gazeuse croît. Les dimensions typiques utilisées dans de telles micropompes à effet de transpiration thermique sont de quelques centaines de microns à moins de un micron.

Pour éviter la réalisation plus complexe de chambres et de canaux de très petites dimensions lorsque la pression du gaz à évacuer approche de la pression atmosphérique, on peut avantageusement concevoir un réseau de micropompes 5 comprenant en série au moins un étage primaire de micropompes à effet de transpiration thermique et au moins un étage secondaire de micropompes à effet piézo-électrique.

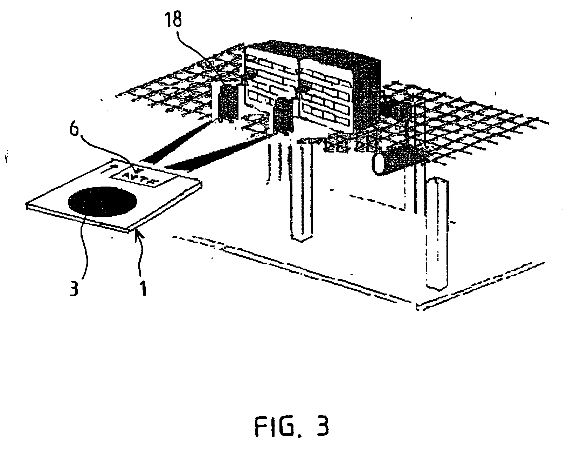

Une utilisation possible du dispositif selon l'invention est illustrée sur la figure 3.

Dans cette utilisation, on a représenté l'enceinte individuelle 1 sous forme d'un boîtier parallélépipédique plat, en illustrant l'échantillon 3 et un dispositif de porte 6. L'enceinte individuelle 1 peut avoir une taille de cassette, en fonction de la taille de l'échantillon 3, par exemple un diamètre de 200 à 500 mm environ et une épaisseur de 30 à 50 mm environ.

L'enceinte individuelle 1 contenant l'échantillon 3 peut être aisément déplacée manuellement jusqu'à un poste de travail 18 dans lequel l'échantillon 3 est extrait de l'enceinte individuelle 1 tout en étant maintenu à une pression similaire de celle régnant dans l'enceinte individuelle 1, par exemple pour une étape d'attaque ou de dépôt sous vide pour fabrication d'un semi-conducteur.

Un autre exemple d'utilisation d'un dispositif selon l'invention est l'encapsulage d'un détecteur de système optique embarqué pour satellite, de manière à le protéger de l'humidité et des autres contaminants pendant les tests de contrôle spécifique avant mise sur orbite.

La présente invention n'est pas limitée aux modes de réalisation qui ont été explicitement décrits, mais elle en inclut les diverses variantes et généralisations qui sont à la portée de l'homme du métier.

## Revendications

1. - Procédé de manipulation et de conservation d'un élément en cours de traitement ou de contrôle, comprenant une étape de transport sous vide contrôlé, **caractérisé en ce que** le transport s'effectue de manière individuelle dans un ensemble formé d'un réseau de micropompes solidaires d'une enceinte individuelle (1) étanche conformée pour contenir un élément (3) et dont les dimensions sont seulement légèrement supérieures à celles dudit élément (3), pour laisser autour dudit élément (3) une atmosphère intérieure de volume réduit (4).

2. - Procédé selon la revendication 1, dans lequel l'enceinte individuelle (1) a un diamètre de 200 à 500mm environ, et une épaisseur de 30 à 50mm environ.

3. - Dispositif de transport et de stockage sous vide contrôlée d'un élément (3) en cours de test ou de fabrication, comprenant :
- une enceinte (1) étanche pour isoler ledit élément de l'atmosphère extérieure,
- des pompes (5), solidaires de l'enceinte (1) et adaptées pour générer et maintenir un vide contrôlé dans l'enceinte (1), les pompes (5) étant connectable à une source d'énergie électrique,
- des moyens de transfert (6, 19) pour introduire ou extraire ledit élément (3) dans l'enceinte (1),
**caractérisé en ce que** :
- l'enceinte (1) est une enceinte individuelle conformée pour contenir un élément (3) qui a des dimensions seulement légèrement supérieures à celles de l'élément (3) de manière à laisser autour de l'élément (3) une atmosphère intérieure de volume réduit (4),
- les pompes (5) sont constituées d'un réseau de micropompes solidaires de ladite enceinte.

4. - Dispositif selon la revendication 3, dans lequel l'enceinte individuelle (1) a un diamètre de 200 à 500mm environ, et une épaisseur de 30 à 50mm environ.

5. - Dispositif selon l'une des revendications 3 ou 4, dans lequel l'ensemble formé par l'enceinte individuelle (1) et le réseau de micropompes (5) est un ensemble autonome portable incluant une source interne d'énergie électrique (7) pour alimenter au moins temporairement le réseau de micropompes (5).

6. - Dispositif selon la revendication 5, dans lequel ledit ensemble a un diamètre de 200 à 500mm environ, et une épaisseur de 30 à 50mm environ.

7. - Dispositif selon l'une des revendications 3 ou 4, **caractérisé en ce que** l'ensemble formé par l'enceinte individuelle (1) et le réseau de micropompes (5) est fixe et constitue une chambre de transfert dans une installation de fabrication de semi-conducteurs.

8. - Dispositif selon l'une quelconque des revendications 3 à 7, **caractérisé en ce que** le réseau de micropompes (5) comprend des micropompes fonctionnant par effet de transpiration thermique.

9. - Dispositif selon la revendication 8, **caractérisé en ce que** le réseau de micropompes (5) comprend une succession de chambres (12, 13) reliées par des canaux (14) dont au moins une dimension transversale est approximativement égale ou inférieure au libre parcours moyen des molécules de gaz présentes dans les micropompes (5), et avec des moyens pour créer et maintenir une différence de température entre les chambres successives (12, 13) afin de générer un effet de pompage.

10. - Dispositif selon la revendication 9, **caractérisé en ce que** les moyens pour créer et maintenir une différence de température entre les chambres successives (12, 13) comprennent une résistance électrique (17) disposée au voisinage de l'entrée de la seconde (13) des deux chambres successives.

11. - Dispositif selon la revendication 9, **caractérisé en ce que** les moyens pour créer et maintenir une différence de température comprennent des jonctions à effet Peltier logées au voisinage des entrées des chambres (12, 13) successives.

12. - Dispositif selon l'une quelconque des revendications 3 à 7, **caractérisé en ce que** le réseau de micropompes (5) comprend des micropompes à micromembranes.

13. - Dispositif selon l'une quelconque des revendications 3 à 7, **caractérisé en ce que** le réseau de micropompes (5) comprend des micropompes à effet piézo-électrique.

14. - Dispositif selon l'une quelconque des revendications 3 à 7, **caractérisé en ce que** le réseau de micropompes (5) comprend en série au moins un étage primaire de micropompes à effet de transpiration thermique et au moins un étage secondaire de micropompes à effet piézo-électrique.

15. - Dispositif selon l'une quelconque des revendications 3 à 14, **caractérisé en ce qu'**il comprend en outre des microcapteurs de température (8) et de pression (9) et un analyseur de gaz (10), pour contrôler l'atmosphère dans l'enceinte individuelle (1) et pour commander le réseau de micropompes (5) par l'intermédiaire d'un microcalculateur embarqué (11).

## Claims

1. Method of handling and storing an item during processing or testing, the method including a step of transport in a controlled vacuum, which method is **characterised in that** the item is transported individually in a combination of an array of micropumps fastened to a seated individual enclosure (1) conformed to contain an item (3), the dimensions of said enclosure being only slightly greater than those of said item (3) to leave a small-volume interior atmosphere (4) around said item (3).

2. Method according to claim 1, in which the individual enclosure (1) has a diameter of approximately 200 to 500 mm and a thickness of approximately 30 to 50 mm.

3. Device for transporting and storing an item (3) in a controlled vacuum during testing or manufacture, the device including:
- a sealed enclosure (1) to isolate said item from the external atmosphere,
- pumps (5) fastened to the enclosure (1) and adapted to generate and maintain a controlled vacuum in the enclosure (1), the pumps (5) being able to be connected to an electrical power supply, and
- transfer means (6, 19) for introducing the item (3) into the enclosure (1) and extracting it therefrom,
**Characterised in that**:
- the enclosure (1) is an individual enclosure conformed to contain the item (3), the dimension of said enclosure being only slightly greater than those of the item (3) so as to leave a small-volume interior atmosphere (4) around the item (3), and
- the pumps (5) consist of an array of micropumps fastened to said enclosure.

4. Device according to claim 3, in which the individual enclosure (1) has a diameter of approximately 200 to 500 mm and a thickness of approximately 30 to 50 mm.

5. Device according to claim 3 or 4, in which the combination of the individual enclosure (1) and the array of micropumps (5) constitutes a portable self-contained system including an internal electrical power supply (7) for supplying power at least temporarily to the array of micropumps (5).

6. Device according to claim 5, in which said system has a diameter of approximately 200 to 500 mm and a thickness of approximately 30 to 50 mm.

7. Device according to claim 3 or 4, **characterised in that** the combination of the individual enclosure (1) and the array of micropumps (5) is fixed and constitutes a transfer chamber in a semiconductor fabrication installation.

8. Device according to any of claims 3 to 7, **characterised in that** the array of micropumps (5) comprises thermal transpiration micropumps.

9. Device according to claim 8, **characterised in that** the array of micropumps (5) comprises a succession of chambers (12, 13) linked by passages (14) of which at least one transverse dimension is approximately equal to or less than the mean free path of the gas molecules present in the micropumps (5) and means for creating and maintaining a temperature difference between the successive chambers (12, 13) in order to generate a pumping effect.

10. Device according to claim 9, **characterised in that** the means for creating and maintaining a temperature difference between the successive chambers (12, 13) include an electrical resistance (17) in the vicinity of the inlet of the second chamber (13) of two successive chambers.

11. Device according to claim 9, **characterised in that** the means for creating and maintaining a temperature difference comprise Peltier effect junctions accommodated in the vicinity of the inlets of the successive chambers (12, 13).

12. Device according to any of claims 3 to 7, **characterised in that** the array of micropumps (5) comprises micromembrane micropumps.

13. Device according to any of claims 3 to 7, **characterised in that** the array of micropumps (5) comprises piezo-electric micropumps.

14. Device according to any of claims 3 to 7, **characterised in that** the array of micropumps (5) comprises a series of at least one primary stage of thermal transpiration micropumps and at least one secondary stage of piezo-electric micropumps.

15. Device according to any of claims 3 to 14, **characterised in that** it further includes a temperature microsensor (8), a pressure microsensor (9) and a gas analyser (10) for the atmosphere in the individual enclosure (1) and for controlling the array of micropumps (5) via an on-board microcomputer (11).

## Patentansprüche

1. - Verfahren zur Manipulation und Aufbewahrung eines in der Verarbeitung oder Kontrolle befindlichen Elements, beinhaltend einen Schritt zum Transport unter einem kontrollierten Vakuum, **dadurch gekennzeichnet, dass** der Transport auf individuelle Weise in einer Baugruppe erfolgt, die aus einem Netzwerk von Mikropumpen besteht, die fest mit einem dichten Einzelraum (1) verbunden sind, welcher so geformt ist, dass er ein Element (3) aufnehmen kann, und dessen Abmessungen nur geringfügig größer als diejenigen des besagten Elements (3) sind, so dass um das besagte Element (3) herum eine Innenatmosphäre von geringerem Volumen (4) verbleibt.

2. - Verfahren gemäß Anspruch 1, in welchem der besagte Einzelraum (1) einen Durchmesser von etwa 200 bis 500 mm und eine Dicke von etwa 30 bis 50 mm hat.

3. - Vorrichtung zum Transport und zur Aufbewahrung eines in der Verarbeitung oder Kontrolle befindlichen Elements (3) unter Vakuum, beinhaltend
- einen dichten Einzelraum (1) zum Isolieren des besagten Elements gegen die Außenatmosphäre,
- Pumpen (5), die mit dem Einzelraum (1) fest verbunden und dafür ausgelegt sind, ein kontrolliertes Vakuum im Einzelraum (1) zu erzeugen und aufrecht zu erhalten, wobei die Pumpen (5) an eine elektrische Energiequelle anschließbar sind,
- Transfermittel (6, 19) zum Einbringen oder Herausnehmen des besagten Elements (3) in den oder aus dem Raum (1),
**dadurch gekennzeichnet, dass**
- der Raum (1) eine individuelle Ummantelung ist, die so ausgelegt ist, dass sie ein Element (3) aufnehmen kann und Abmessungen hat, die geringfügig größer als diejenigen des Elements sind, so dass um das Element (3) herum eine Innenatmosphäre von geringerem Volumen (4) verbleibt, und
- dass die Pumpen (5) aus einem Netzwerk von fest mit dem Raum verbundenen Mikropumpen gebildet werden.

4. - Vorrichtung gemäß Anspruch 3, in welcher der Einzelraum (1) einen Durchmesser von etwa 200 bis 500 mm und eine Dicke von etwa 30 bis 50 mm hat.

5. - Vorrichtung gemäß einem der Ansprüche 3 oder 4, in welcher die durch den Einzelraum (1) und das Mikropumpen-Netzwerk (5) gebildete Baugruppe eine eigenständige tragbare Baugruppe ist, die eine interne elektrische Energiequelle (7) für die zumindest vorübergehende Versorgung des Mikropumpen-Netzwerks (5) beinhaltet.

6. - Vorrichtung gemäß Anspruch 5, in welcher die besagte Baugruppe einen Durchmesser von etwa 200 bis 500 mm und eine Dicke von etwa 30 bis 50 mm hat.

7. - Vorrichtung gemäß einem der Ansprüche 3 oder 4, **dadurch gekennzeichnet, dass** die durch den Einzelraum (1) und das Mikropumpen-Netzwerk (5) gebildete Baugruppe ortsfest ist und eine Transferkammer in einer Anlage zur Halbleiterherstellung bildet.

8. - Vorrichtung gemäß einem oder mehreren der Ansprüche 3 bis 7, **dadurch gekennzeichnet, dass** das Mikropumpen-Netzwerk (5) Mikropumpen beinhaltet, die nach dem Prinzip der thermischen Transpiration arbeiten.

9. - Vorrichtung gemäß Anspruch 8 , **dadurch gekennzeichnet, dass** das Mikropumpen-Netzwerk (5) eine Aufeinanderfolge von Kammern (12, 13) beinhaltet, die über Kanäle (14) miteinander verbunden sind, von denen mindestens eine Querschnittsabmessung ungefähr so groß wie oder kleiner als die mittlere freie Weglänge der in den Mikropumpen (5) befindlichen Gasmoleküle ist, und mit Mitteln versehen ist, um eine Temperaturdifferenz zwischen den aufeinander folgenden Kammern (12, 13) zu erzeugen, aufrecht zu erhalten und so einen Pumpeffekt zu bewirken.

10. - Vorrichtung gemäß Anspruch 9, **dadurch gekennzeichnet, dass** die Mittel zum Erzeugen und Aufrechterhalten einer Temperaturdifferenz zwischen den aufeinander folgenden Kammern (12, 13) einen elektrischen Widerstand (17) beinhalten, der in der Nähe des Eingangs der zweiten (13) der aufeinander folgenden Kammern angeordnet ist.

11. - Vorrichtung gemäß Anspruch 9, **dadurch gekennzeichnet, dass** die Mittel zum Erzeugen und Aufrechterhalten einer Temperaturdifferenz Peltier-Elemente beinhalten, die in der Nähe der Eingänge der der aufeinander folgenden Kammern (12, 13) angeordnet sind.

12. - Vorrichtung gemäß einem oder mehreren der Ansprüche 3 bis 7, **dadurch gekennzeichnet, dass** das Mikropumpen-Netswerk (5) Mikromembran-Mikropumpen beinhaltet.

13. - Vorrichtung gemäß einem oder mehreren der Ansprüche 3 bis 7, **dadurch gekennzeichnet, dass** das Mikropumpen-Netzwerk (5) Mikropumpen beinhaltet, die nach dem piezoelektrischen Effekt arbeiten.

14. - Vorrichtung gemäß einem oder mehreren der Anspruche 3 bis 7, **dadurch gekennzeichnet, dass** das Mikropumpen-Netzwerk (5) mindestens eine nach dem Prinzip der thermischen Transpiration arbeitende primäre Mikropumpenstufe und mindestens eine nach dem piezoelektrischen Effekt arbeitende sekundäre Mikropumpenstufe beinhaltet, die in Serie angeordnet sind.

15. - Vorrichtung gemäß einem oder mehreren der Ansprüche 3 bis 14, **dadurch gekennzeichnet, dass** diese außerdem Mikrosensoren für die Temperatur (8) und den Druck (9) sowie einen Gasanalysator (10) zum Kontrollieren der Atmosphäre im Einzelraum (1) und zum Steuern des Mikropumpen-Netzwerks (5) mittels eines eingebauten Mikrorechners (11) beinhaltet.
